# EUROPÄISCHE PATENTANMELDUNG

(11) **EP 4 679 495 A1**
(43) Veröffentlichungstag der Anmeldung: **14.01.2026**
(21) Anmeldenummer: 24188071.5
(22) Anmeldetag: 11.07.2024
(51) Int. Cl.: H01L 21/48, H01L 23/427

(54) **VERFAHREN ZUR HERSTELLUNG EINER KÜHLVORRICHTUNG FÜR EINE HALBLEITERANORDNUNG**

(71) Anmelder: Siemens Aktiengesellschaft, 80333 München (DE)
(72) Erfinder: Kiesel, Alexander, 82467 Garmisch-Partenkirchen (DE); Brede, Claus, 91058 Erlangen (DE); Schwarz, Florian, 91466 Gerhardshofen (DE)
(74) Vertreter: Siemens Patent Attorneys

(57) **Zusammenfassung**

Die Erfindung betrifft ein Verfahren zur Herstellung einer Kühlvorrichtung (24) für eine Halbleiteranordnung (54). Um eine einfache und eine kostengünstigere Herstellung zu ermöglichen, werden folgende Schritte vorgeschlagen: Herstellen (A) eines, insbesondere metallischen, Grundkörpers (2) mit einer ebenen Oberfläche (4), einer ersten Seitenfläche (6) und einer gegenüber der ersten Seitenfläche (6) angeordneten zweiten Seitenfläche (8), wobei durchgängig von der ersten Seitenfläche (6) zur zweiten Seitenfläche (8) und parallel zur Oberfläche (4) verlaufende Kanäle (10) in den Grundkörper (2) eingebracht werden, wobei benachbarte Kanäle (10) jeweils über einen Steg (20) verbunden sind, beidseitiges Einbringen (B) von parallel zur Oberfläche (4) verlaufenden Kontaktierungsnuten (16) und Verbindungsnuten (18), wobei die Verbindungsnuten (18) zwischen benachbarten Kanälen (10) durch teilweises Abtragen des zwischen den benachbarten Kanälen (10) angeordneten Steges (20) angeordnet werden, wobei die Kanäle (10) zwischen der Oberfläche (4) und den Kontaktierungsnuten (16) angeordnet sind und die Verbindungsnuten (18) tiefer als die jeweiligen Kontaktierungsnuten (16) in den Grundkörper (2) hineinragen, Verschließen (C) der Kanäle (10) durch Verpressen zur Ausbildung einer geschlossenen Kanalstruktur (22), Befüllen (D) der Kanalstruktur (22) mit einem Wärmetransportfluid (48), sodass der Grundkörper (2) in unmittelbarem Kontakt mit dem Wärmetransportfluid (48) steht.

## Beschreibung

Die Erfindung betrifft ein Verfahren zur Herstellung einer Kühlvorrichtung für eine Halbleiteranordnung.

Ferner betrifft die Erfindung eine Kühlvorrichtung für eine Halbleiteranordnung.

Überdies betrifft die Erfindung eine Halbleiteranordnung mit mindestens einer derartigen Kühlvorrichtung.

Darüber hinaus betrifft die Erfindung einen Stromrichter mit mindestens einer derartigen Halbleiteranordnung.

Derartige Kühlvorrichtungen kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Stromrichtern zu. Um Elektronikausfälle durch thermische Überlastungen zu vermeiden, werden daher immer effektivere, aber auch kostengünstigere Konzepte zum Entwärmen von Halbleiterelementen benötigt.

Die Offenlegungsschrift EP 4 026 166 A1 beschreibt ein Elektronikmodul umfassend eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Die Offenlegungsschrift WO 2022/128474 A1 einen Heatpipekühlkörper, wobei der Heatpipekühlkörper für einen Betrieb als pulsierende Heatpipe eingerichtet ist, wobei der Heatpipekühlkörper einen Körper aufweist. Zur Verbesserung der Leistungsfähigkeit und Herstellbarkeit des Heatpipekühlkörpers wird vorgeschlagen, dass der Körper im Innern mindestens einen geschlossenen Kanal, insbesondere einen wechselseitig gekrümmten oder mäanderförmig ausgebildeten Kanal, aufweist, wobei der Körper einen ersten Körperabschnitt aufweist, der gekrümmt, wechselseitig gekrümmt, mäanderförmig oder U-förmig ausgebildet ist, wobei der erste Körperabschnitt von einem Kühlmedium, insbesondere einem gasförmigen Kühlmedium, entlang der Oberfläche des ersten Körperabschnitts durchströmbar ist, wobei Abschnitte des Kanals und/oder bei mehr als einem Kanal unterschiedliche Kanäle parallel zueinander angeordnet sind.

Die Offenlegungsschrift EP 4 071 801 A1 beschreibt eine Halbleitermodulanordnung aufweisend einen Kühlkörper und zumindest ein Halbleitermodul, welches auf dem Kühlkörper kontaktiert ist. Um, im Vergleich zum Stand der Technik, eine effektivere Entwärmung und eine kostengünstigere Herstellung zu ermöglichen, wird vorgeschlagen, dass der Kühlkörper einen Kühlkörpergrundkörper und einen Kühlkörperaufsatz umfasst, wobei der Kühlkörperaufsatz auf einer ersten Oberfläche eine Kanalstruktur aufweist, in welcher ein Wärmetransportfluid angeordnet ist, wobei der Kühlkörpergrundkörper eine Kühlkörpergrundkörperoberfläche aufweist, wobei die Kanalstruktur durch eine stoffschlüssige Verbindung mit der Kühlkörpergrundkörperoberfläche des Kühlkörpergrundkörpers hermetisch verschlossen ist, sodass sowohl der Kühlkörperaufsatz als auch der Kühlkörpergrundkörper in unmittelbarem Kontakt mit dem Wärmetransportfluid stehen, wobei durch die hermetisch verschlossene Kanalstruktur und das Wärmetransportfluid eine pulsierende Heatpipe ausgebildet ist, welche mit dem Halbleitermodul in einer thermisch leitfähigen Verbindung steht.

Vor diesem Hintergrund liegt der Erfindung die Aufgabe zugrunde, ein Verfahren zur Herstellung einer Kühlvorrichtung anzugeben, das einfach und kostengünstig zu realisieren ist.

Diese Aufgabe wird erfindungsgemäß durch ein Verfahren zur Herstellung einer Kühlvorrichtung für eine Halbleiteranordnung umfassend folgende Schritte: Herstellen eines, insbesondere metallischen, Grundkörpers mit einer ebenen Oberfläche, einer ersten Seitenfläche und einer gegenüber der ersten Seitenfläche angeordneten zweiten Seitenfläche, wobei durchgängig von der ersten Seitenfläche zur zweiten Seitenfläche und parallel zur Oberfläche verlaufende Kanäle in den Grundkörper eingebracht werden, wobei benachbarte Kanäle jeweils über einen Steg verbunden sind, beidseitiges Einbringen von parallel zur Oberfläche verlaufenden Kontaktierungsnuten und Verbindungsnuten, wobei die Verbindungsnuten zwischen benachbarten Kanälen durch teilweises Abtragen des zwischen den benachbarten Kanälen angeordneten Steges angeordnet werden, wobei die Kanäle zwischen der Oberfläche und den Kontaktierungsnuten angeordnet sind und die Verbindungsnuten tiefer als die jeweiligen Kontaktierungsnuten in den Grundkörper hineinragen, Verschließen der Kanäle durch Verpressen zur Ausbildung einer geschlossenen Kanalstruktur, Befüllen der Kanalstruktur mit einem Wärmetransportfluid, sodass der Grundkörper in unmittelbarem Kontakt mit dem Wärmetransportfluid steht.

Ferner wird die Aufgabe erfindungsgemäß gelöst durch eine Kühlvorrichtung für eine Halbleiteranordnung aufweisend einen, insbesondere metallischen, Grundkörper mit einer ebenen Oberfläche, einer ersten Seitenfläche und einer gegenüber der ersten Seitenfläche angeordneten zweiten Seitenfläche, wobei der Grundkörper durchgängig von der ersten Seitenfläche zur zweiten Seitenfläche und parallel zur Oberfläche verlaufende Kanäle aufweist, wobei benachbarte Kanäle jeweils über einen Steg verbunden sind, wobei in dem Grundkörper parallel zur Oberfläche verlaufende Kontaktierungsnuten und Verbindungsnuten angeordnet sind, wobei die Verbindungsnuten zwischen benachbarten Kanälen durch teilweises Abtragen des zwischen den benachbarten Kanälen angeordneten Steges ausgebildet sind, wobei die Kanäle zwischen der Oberfläche und den Kontaktierungsnuten angeordnet sind und die Verbindungsnuten tiefer als die jeweiligen Kontaktierungsnuten in den Grundkörper hineinragen, wobei die Kanäle an den Kanalenden derartig verpresst sind, dass eine geschlossene Kanalstruktur ausgebildet wird, wobei in der geschlossenen Kanalstruktur ein Wärmetransportfluid angeordnet ist, sodass der Grundkörper in unmittelbarem Kontakt mit dem Wärmetransportfluid steht.

Überdies wird die Aufgabe erfindungsgemäß gelöst durch eine Halbleiteranordnung mit mindestens einer derartigen Kühlvorrichtung, wobei ein Substrat auf der Oberfläche des Grundkörpers, insbesondere stoffschlüssig, verbunden ist, wobei Leistungshalbleiterelemente auf dem Substrat derartig kontaktiert sind, dass während eines Betriebes der Halbleiteranordnung in den Leistungshalbleiterelementen entstehende Verlustwäre über das Substrat an die mit dem Wärmetransportfluid befüllte Kanalstruktur abgegeben wird.

Darüber hinaus wird die Aufgabe erfindungsgemäß gelöst durch einen Stromrichter mit mindestens einer derartigen Halbleiteranordnung.

Die in Bezug auf das Verfahren nachstehend angeführten Vorteile und bevorzugten Ausgestaltungen lassen sich sinngemäß auf die Kühlvorrichtung, die Halbleiteranordnung und den Stromrichter übertragen.

Der Erfindung liegt die Überlegung zugrunde, die Herstellung einer Kühlvorrichtung mit einer geschlossenen Kanalstruktur, welche beispielsweise als, insbesondere pulsierende, Heatpipe und/oder Vapor Chamber verwendbar ist, dadurch zu vereinfachen, dass durchgängige parallel zu einer ebenen Oberfläche eines Grundkörpers verlaufende Kanäle möglichst einfach und kostengünstig so, insbesondere hermetisch, verschlossen werden, dass die geschlossene Kanalstruktur ausgebildet wird. Zusätzlich zur ebenen Oberfläche weist der Grundkörper eine erste Seitenfläche und eine gegenüber der ersten Seitenfläche angeordnete zweite, auf. Insbesondere sind die erste Seitenfläche und die zweite Seitenfläche im Wesentlichen eben ausgebildet und parallel zueinander angeordnet. Beispielsweise ist der Grundkörper quaderartig ausgebildet. Zwischen benachbarten Kanälen sind Stege des Grundkörpers angeordnet. Insbesondere sind jeweils benachbarte Kanäle jeweils über einen Steg des Grundkörpers getrennt. Benachbarte Kanäle werden durch Einbringen von Verbindungsnuten miteinander verbunden, wobei das Einbringen der Verbindungsnuten durch teilweises Abtragen von Stegen im Bereich der Seitenfläche erfolgt. Die Verbindungsnuten ragen tiefer als die jeweiligen Kontaktierungsnuten in den Grundkörper hinein. Beispielsweise erfolgt das teilweise Abtragen der Stege und das Einbringen der parallel zur Oberfläche des Grundkörpers verlaufende Kontaktierungsnuten in einem Fertigungsschritt.

In einem weiteren Schritt erfolgt ein Verschließen der Kanäle durch Verpressen zur Ausbildung der geschlossenen Kanalstruktur, wobei die Kontaktierungsnuten zur Kontaktierung einer Pressvorrichtung dienen. Beispielsweise wird in die Kontaktierungsnut eine Grundplatte eingeführt, wobei ein Stempel oberhalb der Grundplatte auf der ebenen Oberfläche aufgesetzt und, insbesondere senkrecht, in Richtung der Grundplatte gepresst wird. Da die Verbindungsnuten tiefer als die jeweiligen Kontaktierungsnuten in den Grundkörper hineinragen, sind die jeweiligen Kanälen der Kanalstruktur durch die Verbindungsnuten, welche Verbindungskanäle zwischen den Kanälen ausbilden, fluidtechnisch miteinander verbunden. Eine derartige kraftschlüssige Verbindung durch Verpressen ist zuverlässig sowie einfach und kostengünstig herzustellen. Durch das seitliche Verschließen der Kanäle sind, insbesondere im Vergleich zu einer zweiteiligen Konstruktion, kleinere Werkzeuge notwendig, was zusätzlich die Kosten senkt. In einem weiteren Schritt erfolgt ein Befüllen der Kanalstruktur mit einem Wärmetransportfluid, sodass der Grundkörper in unmittelbarem Kontakt mit dem Wärmetransportfluid steht. Das Befüllen kann beispielsweise über eine Befüllöffnung, welche nach dem Befüllen hermetisch dicht verschlossen wird, erfolgen. Eine durch ein derartiges Verfahren hergestellte Kühlvorrichtung ist beispielsweise als, insbesondere pulsierende, Heatpipe und/oder Vapor Chamber betreibbar.

Eine weitere Ausführungsform sieht vor, dass die Verbindungsnuten alternierend im Bereich der Seitenflächen zur Ausbildung einer mäanderartigen Kanalstruktur angeordnet werden. Durch eine derartige mäanderartige Kanalstruktur wird großflächig eine homogene Wärmeabfuhr erreicht.

Eine weitere Ausführungsform sieht vor, dass das Herstellen des Grundkörpers aus einem metallischen Werkstoff mittels Strangpressen erfolgt. Insbesondere ist der Grundkörper aus Aluminium oder einer Aluminiumlegierung als Endlosprofil mittels Strangpressen hergestellt. Beispielsweise ist beim Strangpressen eine Aluminiumlegierung mit einem Siliziumanteil von bis 1,0 %, insbesondere bis 0,6 %, verwendbar. Somit ist beim Strangpressen, insbesondere im Vergleich zu einem gegossenen Grundkörper, ein niedriger Siliziumanteil verwendbar, sodass durch das Strangpressen mit einer derartigen Legierung eine verbesserte Wärmeleitfähigkeit erreichbar ist. Ferner ist das Strangpressen, insbesondere von Endlosprofilen, einfach und kostengünstig. Insbesondere bei Verwendung von Aluminium oder einer Aluminiumlegierung, welche hinsichtlich ihrer Materialeigenschaften, z.B. im Vergleich zu weiteren metallischen Werkstoffen mit ähnlicher Wärmeleitfähigkeit, eher weich sind, ist durch Verpressen eine kostengünstige Einkapselung erzeugbar.

Eine weitere Ausführungsform sieht vor, dass beim Strangpressen parallel zu den Kanälen verlaufende Kühlrippen hergestellt werden. Somit sind auch die Kühlrippen durch Strangpressen als Endlosprofil herstellbar, was den Herstellungsvorgang vereinfacht und zusätzlich Kosten spart.

Eine weitere Ausführungsform sieht vor, dass das Verpressen der Kanäle mittels eines Greifers erfolgt, wobei die Kontaktierungsnuten jeweils eine, insbesondere parallel zur Oberfläche des Grundkörpers verlaufende Kontaktierungsfläche aufweisen, wobei ein erster Greiferbacken auf der Oberfläche des Grundkörpers und ein zweiter Greiferbacken auf der Kontaktierungsfläche der Kontaktierungsnut kontaktiert wird und wobei die Greiferbacken zum Verschließen der Kanäle zusammengepresst werden. Das Verpressen mittels eines derartigen Greifers erfolgt schnell, einfach und kostengünstig. Ferner wird durch das Zusammenpressen von Greiferbacken, insbesondere im Vergleich zu einer Pressvorrichtung mit Stempel und Grundplatte, eine höhere Zuverlässigkeit der Pressverbindung erreicht.

Eine weitere Ausführungsform sieht vor, dass das Einbringen der Kontaktierungsnuten und Verbindungsnuten mittels eines spanenden Verfahrens erfolgt. Ein derartiges spanendes Verfahren ist beispielsweise Fräsen. Fräsen ist einfach und kostengünstig.

Eine weitere Ausführungsform sieht vor, dass vor dem Verschließen ein, insbesondere metallischer, Dichtstoff in zumindest einen der Kanäle eingelegt und dieser mit verpresst wird. Ein derartiger Dichtstoff kann unter anderem ein metallischer Dichtstoff sein, welcher sich beispielsweise durch seine Festigkeit vom metallischen Werkstoff des Grundkörpers unterscheidet. Der metallische Dichtstoff kann unter anderem weicher als der metallische Werkstoff des Grundkörpers sein. Beispielsweise kann der metallische Dichtstoff Kupfer, Zink und/oder Zinn enthalten. Zusätzlich oder alternativ kann der Dichtstoff einen organischen Werkstoff enthalten. Der organische Werkstoff unter anderem Dichtband oder ein Gummi sein. Durch einen derartigen Dichtstoff wird einfach und kostengünstig eine zusätzlich verbesserte Dichtigkeit der Pressverbindung erreicht.

Eine weitere Ausführungsform sieht vor, dass das Verschließen der Kanäle ein stoffschlüssiges Verbinden der Kanalenden beinhaltet. Beispielsweise erfolgt das stoffschlüssige Verbinden nach dem Verpressen. Eine derartige stoffschlüssige Verbindung kann unter anderem durch Schweißen, Hartlöten oder Kleben hergestellt werden, wobei die Dichtigkeit der Kanalstruktur verbessert und damit die Lebensdauer der Kühlvorrichtung erhöht wird.

Eine weitere Ausführungsform sieht vor, dass das Abtragen von zwischen benachbarten Kanälen angeordneten Stegen im Bereich einer Seitenfläche in unterschiedlichen Tiefen erfolgt, wobei ein inneres Verpressen und ein äußeres Verpressen, insbesondere zur Herstellung eines Umlenkkanals auf der Seitenfläche, erfolgt. Mittels eines durch einseitiges inneres und äußeres Verpressen hergestellten Umlenkkanal ist eine Closed-Loop Pulsierende Heatpipe einfach und kostengünstig herstellbar.

Eine weitere Ausführungsform sieht vor, dass erste innere Stege in einer zweiten Tiefe, welche tiefer als eine erste Tiefe der Kontaktierungsnut ist, abgetragen werden, wobei zweite innere Stege in einer dritten Tiefe, welche weniger tief als die erste Tiefe der Kontaktierungsnut ist, abgetragen werden, wobei das Abtragen alternierend zwischen der zweiten Tiefe und der dritten Tiefe erfolgt. Dadurch ist eine mäanderartigen Kanalstruktur, welche großflächig eine homogene Wärmeabfuhr erzielen kann, einfach und kostengünstig herstellbar.

Eine weitere Ausführungsform sieht vor, dass Verschließen innerer Kanäle durch ein inneres Verpressen erfolgt, wobei durch das innere Verpressen eine innere Presszone ausgebildet wird, welche die inneren Kanäle unter Ausbildung einer Mäanderstruktur verschließt, wobei ein Verschließen äußerer Kanäle durch ein äußeres Verpressen erfolgt, wobei durch das äußere Verpressen eine äußere Presszone ausgebildet wird, welche die äußeren Kanäle unter Ausbildung eines Umlenkkanals verschließt, wobei durch den Umlenkkanal eine Closed-Loop Pulsierende Heatpipe ausgebildet wird. Dadurch ist eine Closed-Loop Pulsierende Heatpipe mit einer mäanderartigen Kanalstruktur einfach und kostengünstig herstellbar.

Eine weitere Ausführungsform sieht vor, dass ein Substrat auf der Oberfläche, insbesondere stoffschlüssig, verbunden wird, wobei Leistungshalbleiterelemente auf dem Substrat derartig kontaktiert werden, dass diese in einer thermisch leitenden Verbindung mit der mit dem Wärmetransportfluid befüllten Kanalstruktur stehen. Das Substrat kann unter anderem als keramisches Substrat, insbesondere als DCB(Direct-Copper-Bonded)-Substrat, ausgeführt sein, sodass eine elektrisch isolierende und thermisch leitfähige Verbindung der Leistungshalbleiterelemente an den Grundkörper hergestellt wird. Beispielsweise ist eine Metallisierung des Substrats durch Löten oder Sintern mit der Oberfläche der Kühlvorrichtung verbunden, wobei die Leistungshalbleiterelemente durch Löten oder Sintern mit einer auf einer gegenüberliegenden Seite des Substrats angeordneten Metallisierung verbunden sind.

Eine weitere Ausführungsform sieht vor, dass beidseitig an den Kanalenden der Kanäle eine Presszone ausgebildet ist, welche die Verbindungsnut begrenzt, wobei die Presszone derartig von den Stegen beabstandet ist, dass ein Kanalquerschnitt im Bereich der Verbindungsnut im Wesentlichen einem Kanalquerschnitt der Kanäle entspricht. Durch eine derartige Ausführung der Verbindungskanäle zwischen den Kanälen, welche durch die Verbindungsnuten ausgebildet werden, wird ein effizienter Wärmeabtransport ermöglicht.

Es zeigen:
- FIG 1: eine schematische Schnittdarstellung eines Grundkörpers für eine Kühlvorrichtung,
- FIG 2: eine schematische dreidimensionale Darstellung des Grundkörpers im Bereich der ersten Seitenfläche,
- FIG 3: eine schematische dreidimensionale Schnittdarstellung des Grundkörpers im Bereich der ersten Seitenfläche,
- FIG 4: eine schematische dreidimensionale Schnittdarstellung des Grundkörpers im Bereich einer zweiten Seitenfläche,
- FIG 5: eine schematische Darstellung eines Verfahrens zur Herstellung einer ersten Ausführungsform einer Kühlvorrichtung mit einem Grundkörper,
- FIG 6: eine schematische dreidimensionale Darstellung eines Verpressens von Kanälen mit-tels eines Greifers,
- FIG 7: eine schematische Schnittdarstellung einer zweiten Ausführungsform einer Kühlvor-richtung im Bereich der ersten Seitenfläche,
- FIG 8: eine schematische Darstellung eines Verfahrens zur Herstellung der zweiten Ausfüh-rungsform der Kühlvorrichtung in einem Querschnitt im Bereich der ersten Seitenflä-che,
- FIG 9: eine schematische Darstellung des Verfahrens zur Herstellung der zweiten Ausfüh-rungsform der Kühlvorrichtung in einem Längsschnitt im Bereich der ersten Seitenflä-che,
- FIG 10: eine schematische Schnittdarstellung einer Halbleiteranordnung mit einer Kühlvorrich-tung und
- FIG 11: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

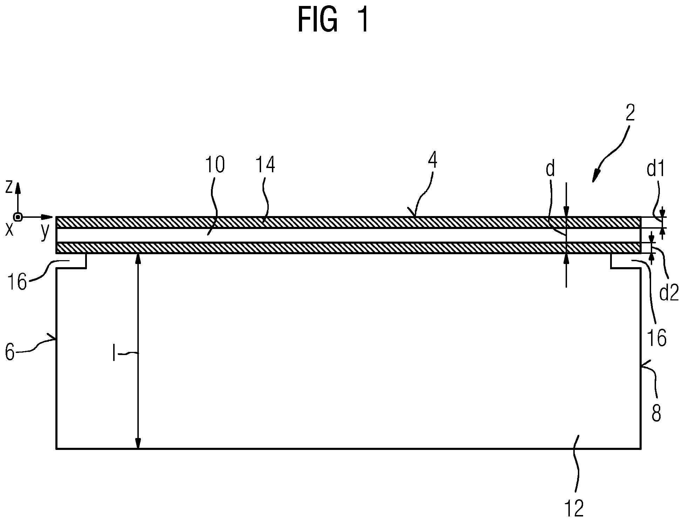

FIG 1 zeigt eine schematische Schnittdarstellung eines Grundkörpers 2 für eine Kühlvorrichtung, welcher aus einem metallischen Werkstoff, z.B. aus Aluminium oder einer Aluminiumlegierung, mittels Strangpressen, insbesondere als Endlosprofil, hergestellt ist. Beispielsweise wird eine Aluminiumlegierung mit einem Siliziumanteil von bis 1,0 %, insbesondere bis 0,6 %, für das Strangpressen verwendet. Insbesondere im Vergleich zu einem gegossenen Grundkörper 2, wird durch einen stranggepressten Grundkörper 2 eine verbesserte Wärmeleitfähigkeit erreicht, da beim Strangpressen ein niedriger Siliziumanteil verwendbar ist. Ein stranggepresster Grundkörper aus einer derartigen Aluminiumlegierung ermöglicht eine verbesserte Wärmespreizung. Alternativ kann der Grundkörper 2 mit den parallel zueinander verlaufenden Kanälen 10 aus einem thermisch leitfähigen Kunststoff, insbesondere als Endlosprofil, mittels Kunststoffextrusion hergestellt werden.

Der im Wesentlichen quaderförmige Grundkörper 2 weist eine ebene Oberfläche 4, eine erste Seitenfläche 6 und eine der ersten Seitenfläche 6 gegenüberliegend angeordnete zweite Seitenfläche 8 auf. Die ebene Oberfläche 4 definiert eine xy-Ebene, wobei eine z-Achse senkrecht zur ebenen Oberfläche verläuft. Mittels des Strangpressverfahrens werden durchgängig von der ersten Seitenfläche 6 zur zweiten Seitenfläche 8 verlaufende Kanäle 10 und Kühlrippen 12 in dem Grundkörper 2 ausgebildet, wobei die Kanäle 10 parallel zur Oberfläche 4 eingebracht werden. Durch eine Länge I der eingebrachten Kühlrippen 12 wird eine Dicke d einer Grundplatte 14 des Grundkörpers 2 definiert. Die Kanäle 10 und die Kühlrippen 12 sind parallel und beispielhaft in y-Richtung verlaufend angeordnet. Die, beispielsweise parallel zueinander verlaufenden, Kühlrippen 12 sind konfiguriert von einem, insbesondere gasförmigen, Kühlmittel umströmt zu werden. Ferner sind die Kanäle 10 im Wesentlichen mittig in die Grundplatte 14 des Grundkörpers 2 eingebracht, sodass eine erste Dicke d1 des metallischen Werkstoffs oberhalb der Kanäle 10 und eine zweite Dicke d2 des metallischen Werkstoffs unterhalb der Kanäle 10 konstant und im Wesentlichen gleich groß sind. Darüber hinaus sind in den beiden Seitenflächen 6, 8 parallel zur Oberfläche 4 verlaufende Kontaktierungsnuten 16 eingebracht. Beispielsweise werden die Kontaktierungsnuten 16 mittels eines spanenden Verfahrens, z.B. Fräsen, in den Grundkörper eingebracht. Beispielhaft werden die Kontaktierungsnuten 16 im Bereich der Kühlrippen 12 ausgefräst.

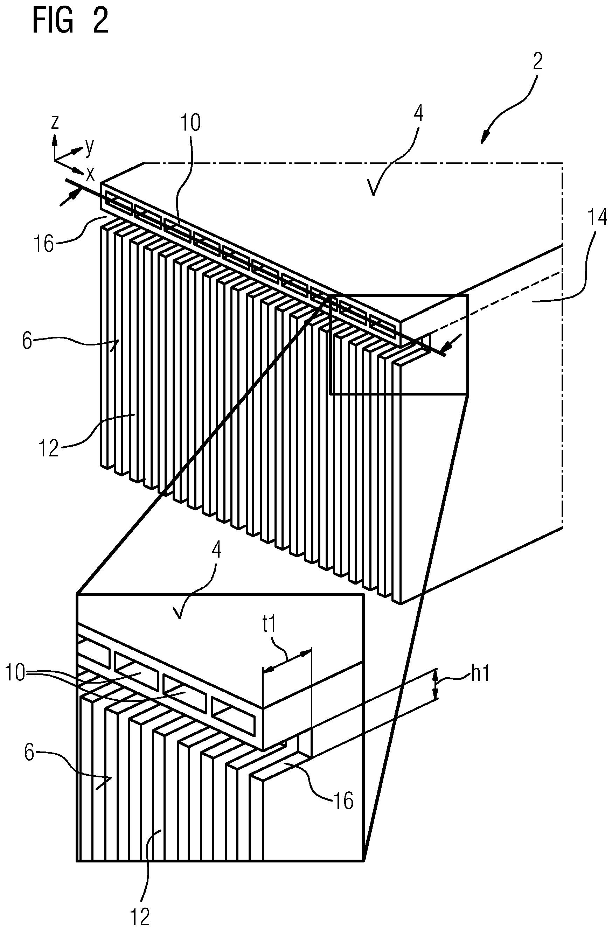

FIG 2 zeigt eine schematische dreidimensionale Darstellung des Grundkörpers 2 im Bereich der ersten Seitenfläche 6. Eine Höhe h1 und eine erste Tiefe t1 der Kontaktierungsnut 16 ist so dimensioniert, dass z.B. Greiferbacken eines Greifers zum Verpressen der Kanäle ansetzbar sind. Die parallel zueinander und zur Oberfläche 4 verlaufenden Kanäle 10 weisen eine im Wesentlichen identische rechteckige, insbesondere quadratische, Querschnittsfläche auf. Beispielsweise beträgt der Kanalquerschnitt 2x2 mm².Zusätzlich sind Kanäle 10 äquidistant zueinander angeordnet. Die weitere Ausführung des Grundkörpers 2 in FIG 2 entspricht der in FIG 1.

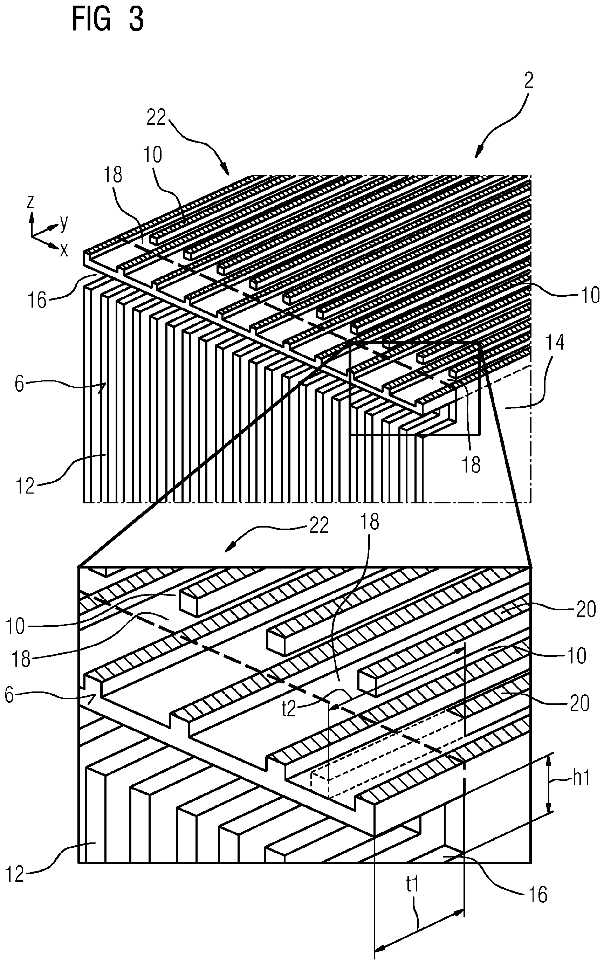

FIG 3 zeigt eine schematische dreidimensionale Schnittdarstellung des Grundkörpers im Bereich der ersten Seitenfläche, wobei Verbindungsnuten 18 zwischen benachbarten Kanälen 10 durch teilweises Abtragen von zwischen den benachbarten Kanälen 10 angeordneten Stegen 20 eingebracht sind. Das Abtragen erfolgt z.B. durch spanendes Verfahren wie Fräsen. Eine zweite Tiefe t2 der Verbindungsnuten 18 ist größer als die erste Tiefe t1 der Kontaktierungsnuten 16, sodass die Verbindungsnuten 18 tiefer als die Kontaktierungsnuten 16 in den Grundkörper 2 hineinragen. Beispielhaft sind die Verbindungsnuten 18 alternierend im Bereich der beiden Seitenflächen 6 ,8 zur Ausbildung einer mäanderartigen Kanalstruktur 22 angeordnet. Die weitere Ausführung des Grundkörpers 2 in FIG 3 entspricht der in FIG 2.

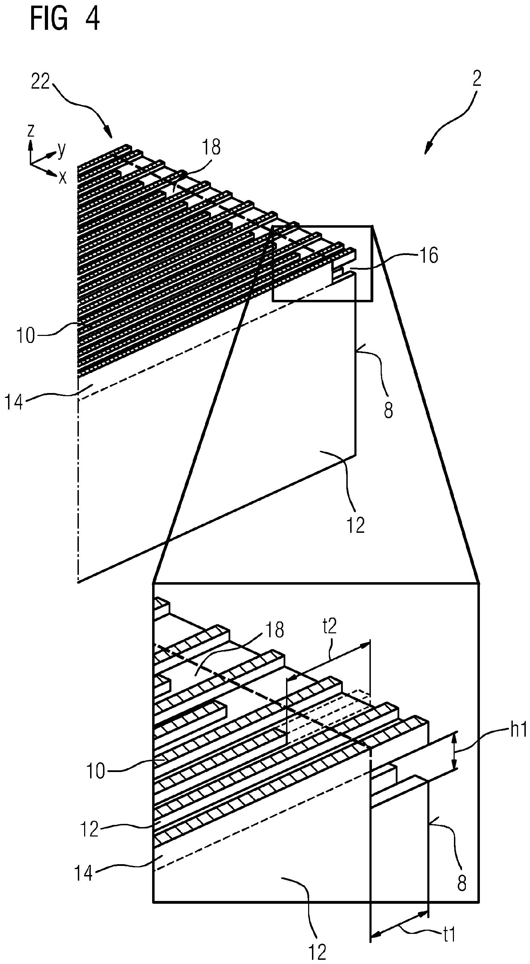

FIG 4 zeigt eine schematische dreidimensionale Schnittdarstellung des Grundkörpers 2 im Bereich einer zweiten Seitenfläche 8. Der Grundkörper 2 aus den Figuren 3 und 4 ist symmetrisch bzgl. einer yz-Ebene ausgeführt.

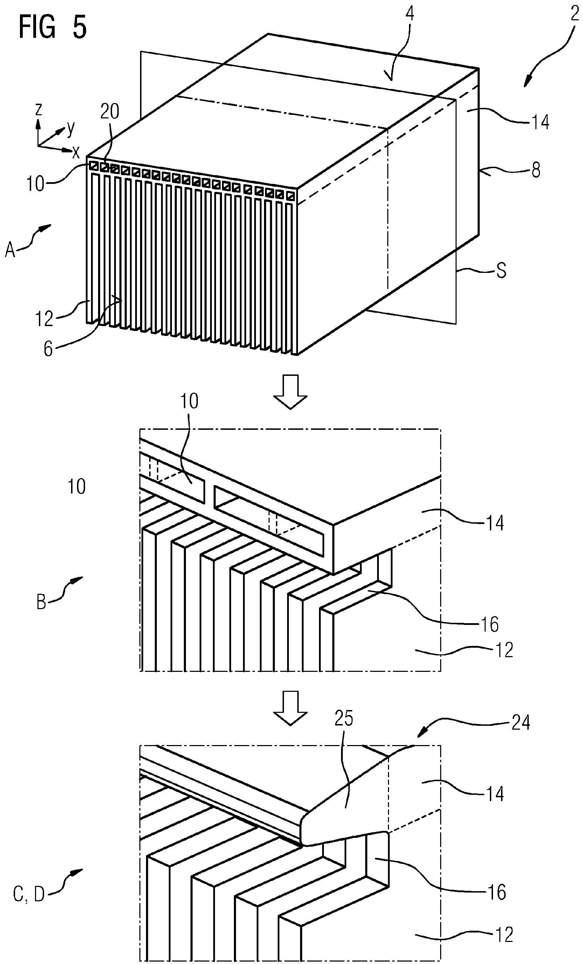

FIG 5 zeigt ein Verfahren zur Herstellung einer ersten Ausführungsform einer Kühlvorrichtung 24 mit einem Grundkörper 2, welcher in den vorherigen Figuren beschrieben ist. Das Verfahren umfasst ein Herstellen A des metallischen Grundkörpers 2 mittels eines Strangpressverfahrens. Der Grundkörper 2 ist quaderförmig ausgeführt, wobei er ebene parallel zueinander angeordnete Seitenflächen 6, 8 sowie eine senkrecht zu den Seitenflächen 6, 8 angeordnete ebene Oberfläche 4 aufweist. Durch Strangpressen werden durchgängig von der ersten Seitenfläche 6 zur zweiten Seitenfläche 8 verlaufende Kanäle 10 und Kühlrippen 12 in dem Grundkörper 2 eingebracht, wobei benachbarte Kanäle 10 jeweils über einen Steg 20 verbunden sind. Der Grundkörper 2 ist symmetrisch bzgl. einer in der yz-Ebene verlaufenden Symmetrieebene S ausgeführt.

In einem weiteren Schritt erfolgt ein beidseitiges Einbringen B von parallel zur Oberfläche 4 verlaufenden Kontaktierungsnuten 16 und Verbindungsnuten 18, wobei die Verbindungsnuten 18 zwischen benachbarten Kanälen 10 durch teilweises Abtragen des zwischen den benachbarten Kanälen 10 angeordneten Steges 20 ausgebildet werden. Die Kontaktierungsnuten 16 werden so eingebracht, dass die Kanäle 10 zwischen der Oberfläche 4 und den Kontaktierungsnuten 16 angeordnet sind und die Verbindungsnuten 18 tiefer als die jeweiligen Kontaktierungsnuten 16 in den Grundkörper 2 hineinragen. Das Abtragen kann unter anderem mittels eines spanenden Verfahrens, beispielsweise durch Fräsen, erfolgen. Beispielhaft werden die Verbindungsnuten 18 alternierend im Bereich der Seitenflächen 6 ,8 zur Ausbildung einer mäanderartigen Kanalstruktur 22 ausgebildet.

In einem weiteren Schritt erfolgt ein Verschließen C der Kanäle 10 durch Verpressen zur Ausbildung einer geschlossenen Kanalstruktur 22 und ein Befüllen D der geschlossenen Kanalstruktur 22 mit einem Wärmetransportfluid, sodass der Grundkörper 2 im Bereich der Kanäle 10 in unmittelbarem Kontakt mit dem Wärmetransportfluid steht. Durch das Verpressen wird eine Presszone 25 ausgebildet, welche die Verbindungsnuten 18 begrenzt. Die Presszone 25 ist derartig von den Stegen 20 beabstandet, dass ein Kanalquerschnitt im Bereich der Verbindungsnut 18 im Wesentlichen einem Kanalquerschnitt der Kanäle 10 entspricht.

Zusätzlich kann das Verschließen C der Kanäle 10 ein stoffschlüssiges Verbinden der Kanalenden beinhalten. Beispielsweise erfolgt das stoffschlüssige Verbinden nach dem Verpressen. Das stoffschlüssige Verbinden kann unter anderem durch Schweißen, Hartlöten oder Kleben erfolgen und kann die Dichtigkeit der Kanalstruktur 22 verbessern.

Optional kann vor dem Verschließen C ein Dichtstoff in zumindest einen der Kanäle 10 im Bereich der herzustellenden Pressverbindung eingelegt werden, wobei der Dichtstoff mit verpresst wird, um eine verbesserte Dichtigkeit der Pressverbindung zu erreichen. Ein derartiger Dichtstoff kann unter anderem ein metallischer Dichtstoff sein, welcher sich beispielsweise durch seine Festigkeit vom metallischen Werkstoff des Grundkörpers 2 unterscheidet. Der metallische Dichtstoff kann unter anderem weicher als der metallische Werkstoff des Grundkörpers 2 sein. Beispielsweise kann der metallische Dichtstoff Kupfer, Zink und/oder Zinn enthalten. Zusätzlich oder alternativ kann der Dichtstoff einen organischen Werkstoff enthalten. Der organische Werkstoff unter anderem Dichtband oder ein Gummi sein.

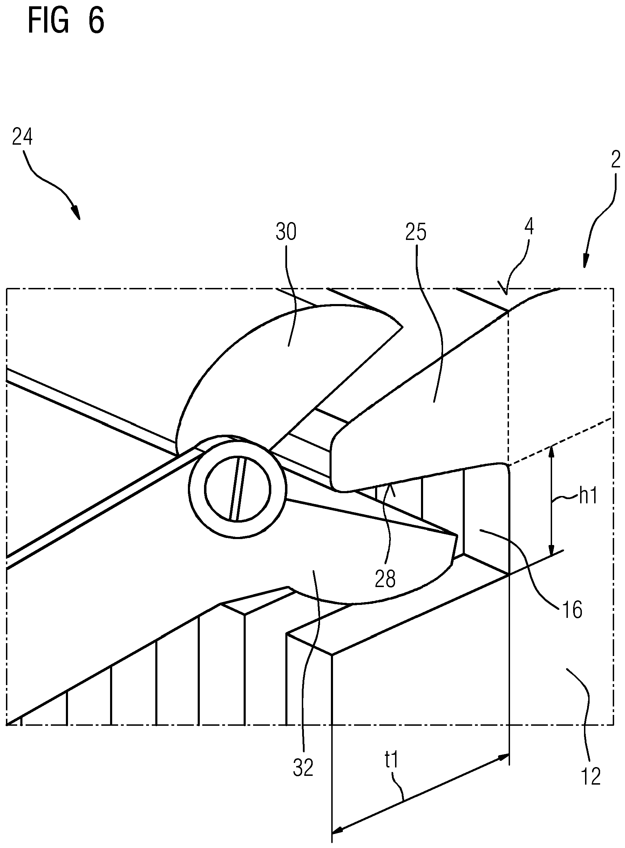

FIG 6 zeigt eine schematische dreidimensionale Darstellung eines Verpressens von Kanälen 10 mittels eines Greifers 26. Die Kontaktierungsnut 16 weist eine parallel zur Oberfläche 4 des Grundkörpers 2 verlaufende Kontaktierungsfläche 28 auf, wobei ein erster Greiferbacken 30 auf der Oberfläche 4 des Grundkörpers 2 und ein zweiter Greiferbacken 32 auf der Kontaktierungsfläche 28 der Kontaktierungsnut 16 kontaktiert wird und wobei die Greiferbacken 30, 32 zum Verschließen der Kanäle 10 zusammengepresst werden. Weitere bzw. vorherige Verfahrensschritte zur Herstellung der Kühlvorrichtung 24 in FIG 6 entsprechen denen in FIG 5.

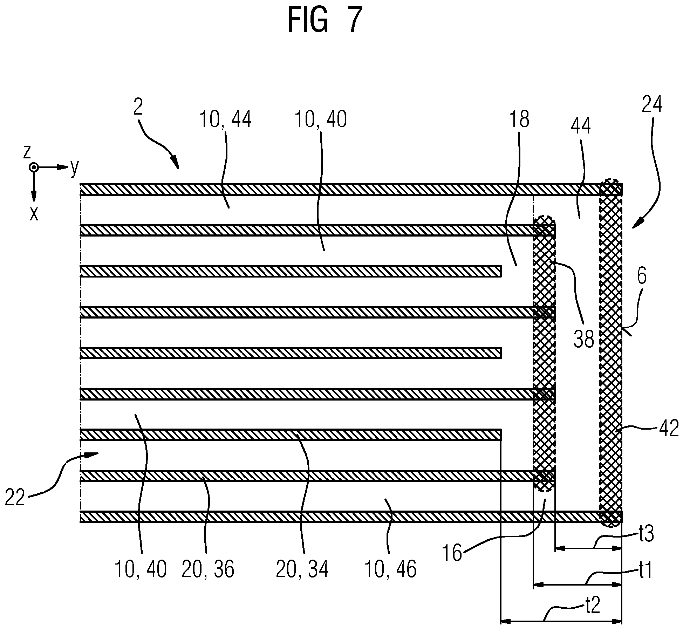

FIG 7 zeigt eine schematische Schnittdarstellung einer zweiten Ausführungsform einer Kühlvorrichtung 24 im Bereich der ersten Seitenfläche 6, wobei die zwischen benachbarten Kanälen 10 angeordneten Stege 20 in unterschiedlichen Tiefen t2, t3 abgetragen wurden. Erste innere Stege 34 sind in einer zweiten Tiefe t2, welche tiefer als eine erste Tiefe t1 der Kontaktierungsnut 16 ist, abgetragen, während zweite innere Stege 36 in einer dritten Tiefe t3, welche weniger tief als die erste Tiefe der Kontaktierungsnut 16 ist, abgetragen sind. Eine innere Presszone 38 verschließt innere Kanäle 40 der Kanalstruktur 22. Die ersten inneren Stege 34 und die zweiten inneren Stege 36 sind alternierend zur Ausbildung einer Mäanderstruktur angeordnet. Eine äußere Presszone 42 ist zur Herstellung eines Umlenkkanals 44, welcher die äußeren Kanäle 46 der Kanalstruktur 22 verbindet, ausgebildet. Durch den Umlenkkanal 44 wird eine Closed-Loop Pulsierende Heatpipe (CLPHP) ausgebildet. Die weitere Ausführung der Kühlvorrichtung 24 in FIG 7 entspricht der in FIG 5.

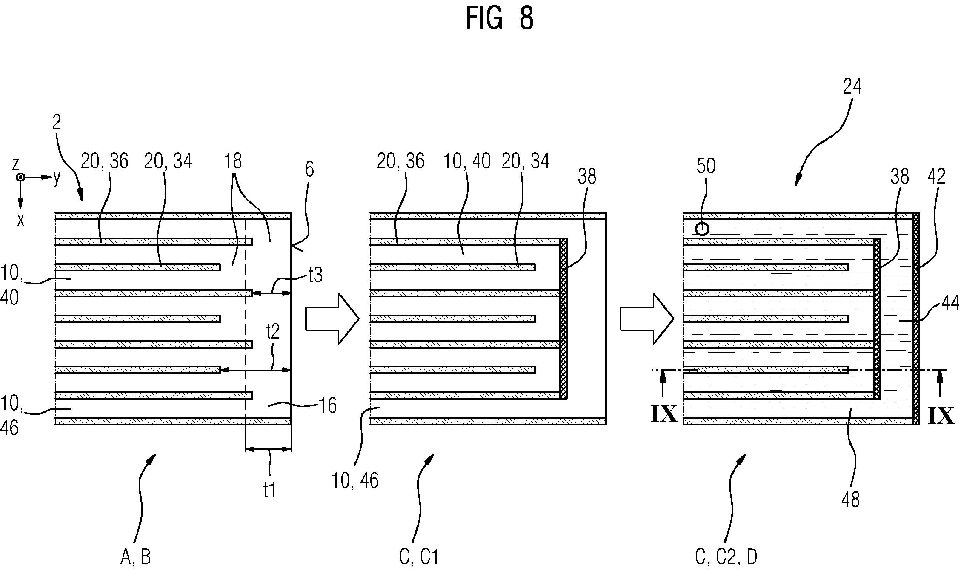

FIG 8 zeigt eine schematische Darstellung eines Verfahrens zur Herstellung der zweiten Ausführungsform der Kühlvorrichtung 24 in einem Querschnitt im Bereich der ersten Seitenfläche 6. Nach dem Herstellen A des metallischen Grundkörpers 2 mittels eines Strangpressverfahrens erfolgt das Einbringen B von parallel zur Oberfläche 4 verlaufenden Kontaktierungsnuten 16 und Verbindungsnuten 18. Die Verbindungsnuten 18 werden durch teilweises Abtragen der zwischen benachbarten Kanälen 10 angeordneten Stege 20 in unterschiedlichen Tiefen t2, t3 hergestellt. Das teilweise Abtragen in unterschiedlichen Tiefen t2, t3 erfolgt alternierend, sodass wechselnd erste innere Stege 34 und zweite innere Stege 36 ausgebildet werden. Die Herstellung der Verbindungsnuten 18 im Bereich der zweiten Seitenfläche 8 erfolgt gemäß des in FIG 5 beschriebenen Verfahrens.

In einem weiteren Schritt erfolgt ein Verschließen C der inneren Kanäle 40 durch ein inneres Verpressen C1, wobei durch das innere Verpressen C1 eine innere Presszone 38 ausgebildet wird, welche die inneren Kanäle 40 der Kanalstruktur 22 im Bereich der ersten Seitenfläche 6 verschließt, sodass eine Mäanderstruktur ausgebildet wird.

In einem weiteren Schritt erfolgt ein Verschließen C der äußeren Kanäle 46 durch ein äußeres Verpressen C2, wobei durch das äußeres Verpressen C2 eine äußere Presszone 42 ausgebildet wird, welche die äußeren Kanäle 46 im Bereich der ersten Seitenfläche 6 verschließt. Durch die äußere Presszone 42 wird ein Umlenkkanal 44 ausgebildet, welcher die äußeren Kanäle 46 der Kanalstruktur 22 verbindet. Das Verschließen C der Kanäle 10 im Bereich der zweiten Seitenfläche 8 erfolgt gemäß des in FIG 5 beschriebenen Verfahrens. Daraufhin erfolgt ein Befüllen D der Kanalstruktur 22 mit einem Wärmetransportfluid 48. Das Befüllen D erfolgt beispielhaft durch einen Standardprozess über eine Befüllöffnung 50, welche nach dem Befüllen D hermetisch dicht verschlossen wird. Die weitere Ausführung des Verfahrens in FIG 8 entspricht dem in FIG 5.

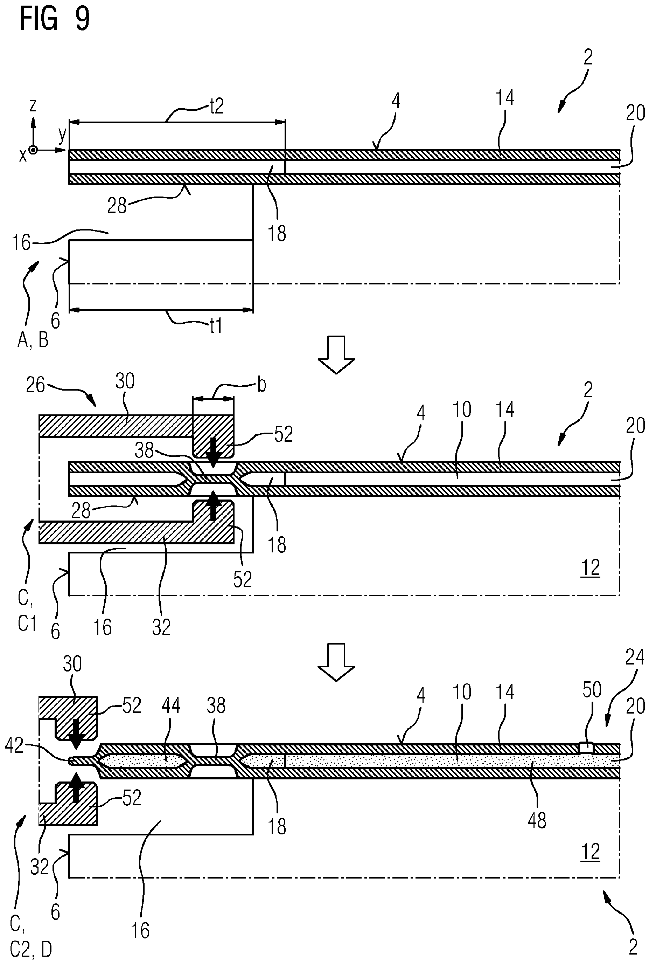

FIG 9 zeigt eine schematische Darstellung des Verfahrens zur Herstellung der zweiten Ausführungsform der Kühlvorrichtung 24 in einem Längsschnitt im Bereich der ersten Seitenfläche. Das innere Verpressen C1 erfolgt mittels eines Greifers 26, wobei ein erster Greiferbacken 30 auf der Oberfläche 4 des Grundkörpers 2 und ein zweiter Greiferbacken 32 auf der Kontaktierungsfläche 28 der Kontaktierungsnut 16 kontaktiert wird. Die Greiferbacken 30, 32 weisen jeweils einen Stempel 52 mit einer Breite b zur Ausbildung der inneren Presszone 38 auf. Die Stempel 52 der Greiferbacken 30, 32 werden zum Verschließen der Kanäle 10 zusammengepresst. Die innere Presszone 38 wird derartig angeordnet, dass ein Kanalquerschnitt im Bereich der Verbindungsnut 18 im Wesentlichen einem Kanalquerschnitt der Kanäle 10 entspricht. Das äußere Verpressen C2 zur Ausbildung der äußeren Presszone 42 erfolgt beispielhaft mittels desselben Greifers 26. Durch die äußere Presszone 42 und die innere Presszone 38 wird der Umlenkkanal 44 ausgebildet, wobei die Presszonen 38, 42 derartig beabstandet werden, dass ein Kanalquerschnitt des Umlenkkanal 44 im Wesentlichen einem Kanalquerschnitt der Kanäle 10 entspricht. Alternativ kann das innere und äußere Verpressen C1, C2 zeitgleich mittels eines Greifers 26, welcher zwei Stempel 52 aufweist, erfolgen. Die weitere Ausführung des Verfahrens in FIG 9 entspricht dem in FIG 8.

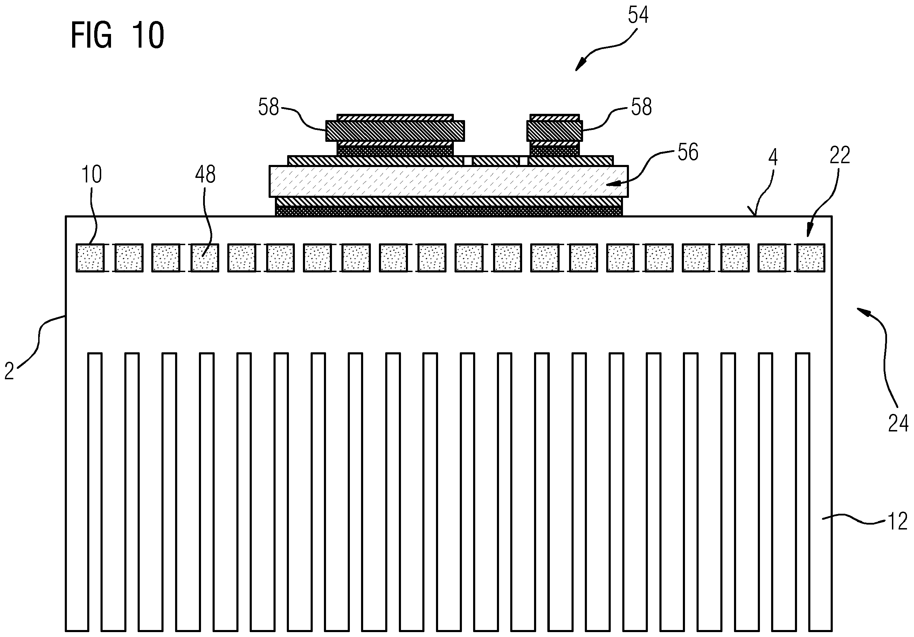

FIG 10 zeigt eine schematische Schnittdarstellung einer Halbleiteranordnung 54 mit einer Kühlvorrichtung 24, wobei ein keramisches Substrat 56 auf der ebenen Oberfläche 4 der Kühlvorrichtung 24 stoffschlüssig verbunden ist. Die Kühlvorrichtung kann beispielsweise wie in FIG 5 oder FIG 7 gezeigt ausgeführt sein. Beispielhaft ist das Substrat 56 durch Löten mit der Oberfläche 4 der Kühlvorrichtung 24 verbunden. Leistungshalbleiterelemente 58 sind auf dem Substrat 56 derartig kontaktiert, dass diese in einer thermisch leitenden Verbindung mit der mit dem Wärmetransportfluid 48 befüllte Kanalstruktur 22, durch welche eine pulsierende Heatpipe ausgebildet wird, stehen. Beispielhaft sind die Leistungshalbleiterelemente 58 durch Löten mit dem Substrat 56, das unter anderem als DCB-Substrat ausgeführt sein kann, verbunden.

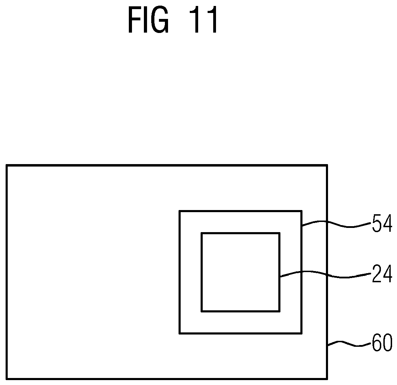

FIG 11 zeigt eine schematische Darstellung eines Stromrichters 60, welcher beispielhaft eine Halbleiteranordnung 54 umfasst. Die Halbleiteranordnung 54 umfasst eine Kühlvorrichtung 24.

Zusammenfassend betrifft die Erfindung ein Verfahren zur Herstellung einer Kühlvorrichtung 24 für eine Halbleiteranordnung 54. Um eine einfache und eine kostengünstigere Herstellung zu ermöglichen, werden folgende Schritte vorgeschlagen: Herstellen A eines, insbesondere metallischen, Grundkörpers 2 mit einer ebenen Oberfläche 4, einer ersten Seitenfläche 6 und einer gegenüber der ersten Seitenfläche 6 angeordneten zweiten Seitenfläche 8, wobei durchgängig von der ersten Seitenfläche 6 zur zweiten Seitenfläche 8 und parallel zur Oberfläche 4 verlaufende Kanäle 10 in den Grundkörper 2 eingebracht werden, wobei benachbarte Kanäle 10 jeweils über einen Steg 20 verbunden sind, beidseitiges Einbringen B von parallel zur Oberfläche 4 verlaufenden Kontaktierungsnuten 16 und Verbindungsnuten 18, wobei die Verbindungsnuten 16 zwischen benachbarten Kanälen 10 durch teilweises Abtragen des zwischen den benachbarten Kanälen 10 angeordneten Steges 20 angeordnet werden, wobei die Kanäle 10 zwischen der Oberfläche 4 und den Kontaktierungsnuten 16 angeordnet sind und die Verbindungsnuten 18 tiefer als die jeweiligen Kontaktierungsnuten 16 in den Grundkörper 2 hineinragen, Verschließen C der Kanäle 10 durch Verpressen zur Ausbildung einer geschlossenen Kanalstruktur 22, Befüllen D der Kanalstruktur 22 mit einem Wärmetransportfluid 48, sodass der Grundkörper 2 in unmittelbarem Kontakt mit dem Wärmetransportfluid 48 steht.

## Patentansprüche

1. Verfahren zur Herstellung einer Kühlvorrichtung (24) für eine Halbleiteranordnung (54) umfassend folgende Schritte:
- Herstellen (A) eines, insbesondere metallischen, Grundkörpers (2) mit einer ebenen Oberfläche (4), einer ersten Seitenfläche (6) und einer gegenüber der ersten Seitenfläche (6) angeordneten zweiten Seitenfläche (8),
wobei durchgängig von der ersten Seitenfläche (6) zur zweiten Seitenfläche (8) und parallel zur Oberfläche (4) verlaufende Kanäle (10) in den Grundkörper (2) eingebracht werden,
wobei benachbarte Kanäle (10) jeweils über einen Steg (20) verbunden sind,
- beidseitiges Einbringen (B) von parallel zur Oberfläche (4) verlaufenden Kontaktierungsnuten (16) und Verbindungsnuten (18),
wobei die Verbindungsnuten (18) zwischen benachbarten Kanälen (10) durch teilweises Abtragen des zwischen den benachbarten Kanälen (10) angeordneten Steges (20) angeordnet werden,
wobei die Kanäle (10) zwischen der Oberfläche (4) und den Kontaktierungsnuten (16) angeordnet sind und die Verbindungsnuten (18) tiefer als die jeweiligen Kontaktierungsnuten (16) in den Grundkörper (2) hineinragen,
- Verschließen (C) der Kanäle (10) durch Verpressen zur Ausbildung einer geschlossenen Kanalstruktur (22),
- Befüllen (D) der Kanalstruktur (22) mit einem Wärmetransportfluid (48), sodass der Grundkörper (2) in unmittelbarem Kontakt mit dem Wärmetransportfluid (48) steht.

2. Verfahren nach Anspruch 1,
wobei durch die geschlossenen Kanalstruktur (22) und das Wärmetransportfluid (48) eine pulsierende Heatpipe ausgebildet wird.

3. Verfahren nach einem der Ansprüche 1 oder 2,
wobei die Verbindungsnuten (18) alternierend im Bereich der Seitenflächen (6 ,8) zur Ausbildung einer mäanderartigen Kanalstruktur (22) angeordnet werden.

4. Verfahren nach einem der vorherigen Ansprüche,
wobei das Herstellen (A) des Grundkörpers (2) aus einem metallischen Werkstoff mittels Strangpressen erfolgt.

5. Verfahren nach Anspruch 4,
wobei beim Strangpressen parallel zu den Kanälen (10) verlaufende Kühlrippen (12) hergestellt werden.

6. Verfahren nach einem der vorherigen Ansprüche,
wobei das Verpressen der Kanäle (10) mittels eines Greifers (26) erfolgt,
wobei die Kontaktierungsnuten (16) jeweils eine, insbesondere parallel zur Oberfläche (4) des Grundkörpers (2) verlaufende Kontaktierungsfläche (28) aufweisen,
wobei ein erster Greiferbacken (30) auf der Oberfläche (4) des Grundkörpers (2) und ein zweiter Greiferbacken (32) auf der Kontaktierungsfläche (28) der Kontaktierungsnut (16) kontaktiert wird,
wobei die Greiferbacken (30, 32) zum Verschließen der Kanäle (10) zusammengepresst werden.

7. Verfahren nach einem der vorherigen Ansprüche,
wobei das Einbringen (B) der Kontaktierungsnuten (16) und Verbindungsnuten (18) mittels eines spanenden Verfahrens erfolgt.

8. Verfahren nach einem der vorherigen Ansprüche,
wobei vor dem Verschließen (C) ein, insbesondere metallischer, Dichtstoff in zumindest einen der Kanäle (10) eingelegt und dieser mit verpresst wird.

9. Verfahren nach einem der vorherigen Ansprüche,
wobei das Verschließen (C) der Kanäle (10) ein stoffschlüssiges Verbinden der Kanalenden beinhaltet.

10. Verfahren nach einem der vorherigen Ansprüche,
wobei das Abtragen von zwischen benachbarten Kanälen (10) angeordneten Stegen (20) im Bereich einer Seitenfläche (6, 8) in unterschiedlichen Tiefen (t2, t3) erfolgt,
wobei ein inneres Verpressen (C1) und ein äußeres Verpressen (C2), insbesondere zur Herstellung eines Umlenkkanals (44) auf der Seitenfläche (6, 8), erfolgt.

11. Verfahren nach Anspruch 10,
wobei erste innere Stege (34) in einer zweiten Tiefe (t2), welche tiefer als eine erste Tiefe (t1) der Kontaktierungsnut (16) ist, abgetragen werden und
wobei zweite innere Stege (36) in einer dritten Tiefe (t3), welche weniger tief als die erste Tiefe (t1) der Kontaktierungsnut (16) ist, abgetragen werden,
wobei das Abtragen alternierend zwischen der zweiten Tiefe (t2) und der dritten Tiefe (t3) erfolgt.

12. Verfahren nach Anspruch 11,
wobei ein Verschließen (C) innerer Kanäle (40) durch ein inneres Verpressen (C1) erfolgt, wobei durch das innere Verpressen (C1) eine innere Presszone (38) ausgebildet wird, welche die inneren Kanäle (40) unter Ausbildung einer Mäanderstruktur verschließt,
wobei ein Verschließen (C) äußerer Kanäle (46) durch ein äußeres Verpressen (C2) erfolgt, wobei durch das äußere Verpressen (C2) eine äußere Presszone (42) ausgebildet wird, welche die äußeren Kanäle (46) unter Ausbildung eines Umlenkkanals (44) verschließt,
wobei durch den Umlenkkanal (44) eine Closed-Loop Pulsierende Heatpipe ausgebildet wird.

13. Verfahren nach einem der vorherigen Ansprüche,
wobei ein Substrat (56) auf der Oberfläche (4), insbesondere stoffschlüssig, verbunden wird,
wobei Leistungshalbleiterelemente (58) auf dem Substrat (56) derartig kontaktiert werden, dass diese in einer thermisch leitenden Verbindung mit der mit dem Wärmetransportfluid (48) befüllten Kanalstruktur (22) stehen.

14. Kühlvorrichtung (24) für eine Halbleiteranordnung (54) aufweisend einen, insbesondere metallischen, Grundkörper (2) mit einer ebenen Oberfläche (4), einer ersten Seitenfläche (6) und einer gegenüber der ersten Seitenfläche (6) angeordneten zweiten Seitenfläche (8),
wobei der Grundkörper (2) durchgängig von der ersten Seitenfläche (6) zur zweiten Seitenfläche (8) und parallel zur Oberfläche (4) verlaufende Kanäle (10) aufweist, wobei benachbarte Kanäle (10) jeweils über einen Steg (20) verbunden sind,
wobei in dem Grundkörper 2 parallel zur Oberfläche (4) verlaufende Kontaktierungsnuten (16) und Verbindungsnuten (18) angeordnet sind, wobei die Verbindungsnuten (18) zwischen benachbarten Kanälen (10) durch teilweises Abtragen des zwischen den benachbarten Kanälen (10) angeordneten Steges (20) ausgebildet sind,
wobei die Kanäle (10) zwischen der Oberfläche (4) und den Kontaktierungsnuten (16) angeordnet sind und die Verbindungsnuten (18) tiefer als die jeweiligen Kontaktierungsnuten (16) in den Grundkörper (2) hineinragen,
wobei die Kanäle (10) an den Kanalenden derartig verpresst sind, dass eine geschlossene Kanalstruktur (22) ausgebildet wird,
wobei in der geschlossenen Kanalstruktur (22) ein Wärmetransportfluid (48) angeordnet ist, sodass der Grundkörper (2) in unmittelbarem Kontakt mit dem Wärmetransportfluid (48) steht.

15. Kühlvorrichtung (24) nach Anspruch 14,
wobei beidseitig an den Kanalenden der Kanäle (10) eine Presszone (25) ausgebildet ist, welche die Verbindungsnut (18) begrenzt,
wobei die Presszone (25) derartig von den Stegen (20) beabstandet ist, dass ein Kanalquerschnitt im Bereich der Verbindungsnut (18) im Wesentlichen einem Kanalquerschnitt der Kanäle (10) entspricht.

16. Halbleiteranordnung (54) mit mindestens einer Kühlvorrichtung (24) nach einem der Ansprüche 14 oder 15,
wobei ein Substrat (56) auf der Oberfläche (4) des Grundkörpers (2), insbesondere stoffschlüssig, verbunden ist,
wobei Leistungshalbleiterelemente (58) auf dem Substrat (56) derartig kontaktiert sind, dass während eines Betriebes der Halbleiteranordnung (54) in den Leistungshalbleiterelementen (58) entstehende Verlustwäre über das Substrat (56) an die mit dem Wärmetransportfluid (48) befüllte Kanalstruktur (22) abgegeben wird.

17. Stromrichter (60) mit mindestens einer Halbleiteranordnung (54) nach Anspruch 16.
